(19) Europäisches Patentamt
European Patent Office
Office européen des brevets

(11) **EP 2 923 213 B1**

(12) **EUROPÄISCHE PATENTSCHRIFT**

(45) Veröffentlichungstag und Bekanntmachung des Hinweises auf die Patenterteilung:
**02.11.2016 Patentblatt 2016/44**

(51) Int Cl.:
*H02S 50/10* *(2014.01)*          *G01R 27/18* *(2006.01)*

(21) Anmeldenummer: **13791812.4**

(86) Internationale Anmeldenummer:
**PCT/EP2013/073918**

(22) Anmeldetag: **15.11.2013**

(87) Internationale Veröffentlichungsnummer:
**WO 2014/079775 (30.05.2014 Gazette 2014/22)**

(54) **ISOLATIONSMESSVERFAHREN FÜR TRAFOLOSE WECHSELRICHTER**

METHOD FOR MEASURING INSULATION OF AN INVERTER WITHOUT TRANSFORMER

PROCÉDÉ DE MESURE DE L'ISOLEMENT D'UN ONDULEUR SANS TRANSFORMATEUR

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.11.2012 DE 102012111250**

(43) Veröffentlichungstag der Anmeldung:
**30.09.2015 Patentblatt 2015/40**

(73) Patentinhaber: **SMA Solar Technology AG 34266 Niestetal (DE)**

(72) Erfinder: **HERMELING, Dirk 32469 Petershagen (DE)**

(56) Entgegenhaltungen:
**EP-A1- 2 372 857          EP-A1- 2 385 384**
**EP-A2- 0 593 007          WO-A1-2012/008022**
**DE-A1-102011 002 084     JP-A- 2006 187 150**

**Beschreibung**

TECHNISCHES GEBIET DER ERFINDUNG

Die Erfindung bezieht sich auf ein Verfahren zur Messung des Isolationswiderstands eines Gleichspannungseingangs eines laufenden transformatorlosen Wechselrichters und von an den Gleichspannungseingang angeschlossenen Gleichspannungsquellen gegenüber Erde. Das heißt, der Gleichspannungseingang und die daran angeschlossenen Gleichspannungsquellen sind ungeerdet und in Hinblick auf ihre Isolation gegenüber Erde zu überwachen. Diese Überwachung soll nicht bei abgeschaltetem Wechselrichter erfolgen, also wenn sein Gleichspannungseingang von seinem Wechselspannungsausgang getrennt ist, sondern im Betrieb des Wechselrichters, in dem es zu Verschiebungen des elektrischen Potentials am Gleichspannungseingang und der daran angeschlossenen Gleichspannungsquellen gegenüber Erde kommen kann.

Als transformatorloser Wechselrichter wird hier jeder Wechselrichter bezeichnet, der keine galvanische Trennung, d. h. auch keine kapazitive galvanische Trennung, zwischen seinem Gleichspannungseingang und seinem Wechselspannungsausgang aufweist.

STAND DER TECHNIK

Zur Messung des Isolationswiderstands eines Gleichspannungseingangs eines noch nicht laufenden Wechselrichters und von an den Gleichspannungseingang angeschlossenen Gleichspannungsquellen gegenüber Erde ist es bekannt, eine der beiden Eingangsleitungen des Gleichspannungseingangs über einen Shuntwiderstand zu erden, so dass an der anderen Eingangsleitung die Spannung von den Gleichspannungsquellen gegenüber Erde anliegt, und den dabei über den Shuntwiderstand fließenden Erdstrom zu messen. Anschließend wird die Prozedur unter Erdung der anderen Eingangsleitung wiederholt. Diese Vorgehensweise ist im laufenden Betrieb zumindest eines transformatorlosen Wechselrichters mit Erdbezug seines Wechselspannungsausgangs nicht durchführbar, weil sich der Erdbezug des Wechselspannungsausgangs in einem Erdbezug des Gleichspannungseingangs auswirkt. Transformatorlose Wechselrichter weisen zumindest im Betrieb keine galvanische Trennung zwischen ihrem Gleichspannungseingang und ihrem Wechselspannungsausgang auf. Ein Erdbezug des Wechselspannungsausgangs eines Wechselrichters kann zum Beispiel durch direkten Anschluss an ein Wechselspannungsnetz mit Erdbezug gegeben sein, aber beispielsweise auch durch einen geerdeten Sternpunkt einer Primärwicklung eines Transformators, über den die von dem Wechselrichter ausgegebene Wechselspannung in ein Wechselspannungsnetz eingespeist wird.

Aus der DE 38 82 833 T2 ist eine Schaltungsanordnung zur Überwachung und Messung des Isolationswiderstands eines elektrischen Netzes gegen Erde bekannt. Mit einem Treiberkreis wird dem zu überwachenden Netz ein Wechselspannungs-Referenzsignal zugeführt. Die Frequenz des dem Netz zugeführten Wechselspannungs-Referenzsignals liegt unterhalb der Netzfrequenz. Der von dem zugeführten Wechselspannungs-Referenzsignal hervorgerufene, über eine Erdschleife abfließende Ableitstrom wird gemessen, und seine Komponente, die phasengleich mit dem Wechselspannungs-Referenzsignal ist, wird zur Messung des Isolationswiderstands verwendet.

Aus der DE 25 42 811 B1 ist eine Schaltungsanordnung zur Messung des Isolationswiderstands einer erdfreien Starkstromschaltung, insbesondere eines aus einer Stromrichterschaltung gespeisten Gleichstromsystems, bekannt. Dabei ist ein Messkreis, der einen Wechselspannungsgenerator, einen Messwiderstand und ein Ankoppelglied enthält, zwischen das Messobjekt und Erde geschaltet. Mit dem Wechselspannungsgenerator wird ein Prüfspannungssignal in einem bevorzugten Frequenzbereich von 25 bis 500 Hz zwischen Erde und dem Messobjekt angelegt. Der von diesem Prüfspannungssignal hervorgerufene Erdstrom bzw. eine über dem Messwiderstand aufgrund des Erdstroms abfallende Spannung wird phasenrichtig zu dem Prüfspannungssignal gleichgerichtet. Diese gleichgerichtete Spannung wird gemittelt und zusammen mit dem gemittelten Prüfspannungssignal einem Dividierer zugeführt, der eine dem Isolationswiderstand entsprechende Ausgangsspannung ausgibt.

Aus der EP 0 654 673 A1 ist ein Verfahren zur Isolationsüberwachung von ungeerdeten elektrischen Gleichstromnetzen und Wechselstromnetzen, die einen unvermeidbaren ohmschen sowie kapazitiven Isolationswiderstand zwischen Netz und Erde aufweisen, insbesondere von solchen mit angeschlossenen Gleichrichtern und sonstigen Stromrichtern, bekannt. Dazu wird eine abwechselnd verschiedene Impulsspannungswerte aufweisende Impulswechselspannung über eine ohmsche Netzankopplung zwischen Netz und Erde an das zu überwachende Netz als Messspannung angelegt. Für jeden Impulsspannungswert wird der nach dem Einschwingen des Netzes auf diesen Impulsspannungswert zwischen Netz und Erde fließende Messstrom, der von der Größe des Isolationswiderstands des Netzes gegenüber Erde und von dem Impulsspannungswert abhängig ist, direkt oder indirekt als Messstrom-Messwert erfasst. Die Messwertdifferenz jeweils zweier aufeinanderfolgender Messstrom-Messwerte wird zur Bestimmung des ohmschen Isolationswiderstands zwischen Netz und Erde benutzt. Hierbei wird zur Verkürzung der Messzeiten vorgeschlagen, dass für jeden Impulsspannungswert der Messspannung der zeitliche Verlauf des vom momentanen Netz abhängigen Einschwingvorgangs des Messstroms oder einer hiervon abgeleiteten Größe, wie einer Messspannung, bis zum Erreichen des Einschwingzustands überwacht wird und dass unmittelbar nach Erreichen der Einschwingzustände die zugehörigen Messstrom-Messwerte erfasst werden. Dann wird unverzüglich der jeweilige Impulsspannungswert der Impulswechselspannung auf ihren zeitlich nächsten Impulsspannungswert umgeschaltet.

Aus der US 4,200,835 ist ein Verfahren zum Messen des Isolationswiderstands eines laufenden geerdeten Übertragungsleitungssystems bekannt. Dazu wird eine sekundäre Spannung mit einer niedrigeren Frequenz als die Hauptspannung in dem geerdeten Übertragungsleitungssystem eingeführt. Der durch die sekundäre Spannung hervorgerufene Strom wird erfasst und mit der Größe der sekundären Spannung multipliziert, um ein Signal zu erhalten, das proportional zu dem Kehrwert des Isolationswiderstands des Systems ist. Bei der Multiplikation werden die Momentanwerte der sekundären Spannung und des Stroms miteinander multipliziert, und der Mittelwert dieses Produkts wird betrachtet.

Aus der US 2011/0270545 A1 ist ein Verfahren zum Messen von Erdschlussströmen an einem Wechselspannungsausgang eines Wechselrichters bekannt, der nach dem PWM (Pulsweitenmodulations)-Prinzip arbeitet und eine Wechselspannung aus einer Gleichspannung formt. Die Ausgangsströme des Wechselrichters werden an seinem Wechselspannungsausgang gemessen, und die Resultate der Strommessung während zwei gegensätzlichen Schalterstellungen des Wechselrichters werden aufgezeichnet. Der Erdschlussstrom wird auf Basis einer Differenz dieser Messwerte berechnet.

Aus der WO 2010/078669 A1 ist eine Vorrichtung für Photovoltaikkraftwerke zur Einstellung des elektrischen Potentials an Photovoltaikgeneratoren bekannt. Mit dieser Vorrichtung soll eine Nutzung von trafolosen Wechselrichtern mit Photovoltaikgeneratoren ermöglicht werden, die nur mit beschränkten positiven oder negativen Eingangsspannungen beaufschlagt werden dürfen. Die Vorrichtung umfasst einen Wechselrichter zur Wandlung einer eingangsseitig angelegten elektrischen Spannung aus den Photovoltaikgeneratoren, der diese eingangsseitige Spannung in eine ausgangsseitige Wechselspannung umsetzt. Diese Wechselspannung wird mit einem Transformator in eine Übertragungsspannung transformiert. Der Wechselrichter ist mit einer Potentialschiebeeinrichtung zur Verschiebung des im Wechselrichter vorhandenen Spannungspotentials auf ein gewünschtes Niveau gegenüber dem Erdpotential versehen. Die Potentialschiebeeinrichtung kann eine Spannung zwischen dem Gleichspannungseingang oder dem Wechselrichterausgang einerseits und dem Erdpotential andererseits erzeugen und so das Potential am Photovoltaikgenerator gegenüber Erdpotential anheben oder absenken. Solche Potentialschiebeeinrichtungen sind auch aus der EP 2 136 449 A1 und der DE 20 2006 008 936 U1 bekannt.

In der DE 10 2011 050 590 A1, die erst nach dem Anmeldetag der vorliegenden Patentanmeldung veröffentlicht werden wird, ist ein Verfahren zur Messung des Isolationswiderstands eines Gleichspannungseingangs eines laufenden transformatorlosen Wechselrichters und von an den Gleichspannungseingang angeschlossenen Gleichspannungsquellen gegenüber Erde beschrieben, das die Merkmale des Oberbegriffs des unabhängigen Patentanspruchs 1 aufweist. Hier wird das periodische Prüfspannungssignal gegenüber Erde mit einer Wechselspannungsquelle an den Gleichspannungseingang angelegt. Dabei ist mindestens ein Prüfwiderstand mit der Wechselspannungsquelle in Reihe geschaltet, um den über die Wechselspannungsquelle nach Erde abfließenden Ableitstrom zu messen. Das Verfahren ist bei einem transformatorlosen Wechselrichter, dessen Wechselspannungsausgang einen vorgegebenen Erdbezug aufweist, nicht anwendbar wegen der Auswirkungen dieses Erdbezugs auch auf den Gleichspannungseingang des Wechselrichters.

Die WO 2012/008022 A1 offenbart ein Verfahren zur Messung des Isolationswiderstands eines Gleichspannungseingangs eines laufenden transformatorlosen Wechselrichters und von an den Gleichspannungseingang angeschlossenen Gleichspannungsquellen gegenüber Erde, das ebenfalls die Merkmale des Oberbegriffs des unabhängigen Patentanspruchs 1 aufweist. Auch hier wird, wie in der DE 10 2011 050 590 A1, das periodische Prüfspannungssignal gegenüber Erde mit einer Wechselspannungsquelle über einen Prüfwiderstand an den Gleichspannungseingang angelegt. Eine Erkennung von Isolationsfehlern erfolgt anhand von Potentialänderungen der Maxima des angelegten periodischen Prüfspannungssignals in Bezug auf einen Schwellwert. Der Wechselspannungsausgang des transformatorlosen Wechselrichters ist an einen dreiphasigen Motor angeschlossen, dessen Sternpunkt nicht geerdet ist. Das Verfahren ist bei einem vorgegebenen Erdbezug am Wechselspannungsausgang eines laufenden transformatorlosen Wechselrichters auch nicht anwendbar.

## AUFGABE DER ERFINDUNG

Der Erfindung liegt die Aufgabe zugrunde, ein Verfahren zur Messung des Isolationswiderstands eines Gleichspannungseingangs eines laufenden transformatorlosen Wechselrichters und von an dem Gleichspannungseingang angeschlossenen Gleichspannungsquellen gegenüber Erde bereitzustellen, das auch bei einem vorgegebenen Erdbezug des Wechselspannungsausgangs des Wechselrichters durchführbar ist.

## LÖSUNG

Die Aufgabe der Erfindung wird durch ein Verfahren mit den Merkmalen des unabhängigen Patentanspruchs 1 gelöst. Die abhängigen Patentansprüche betreffen bevorzugte Ausführungsformen des erfindungsgemäßen Verfahrens.

## BESCHREIBUNG DER ERFINDUNG

Bei einem erfindungsgemäßen Verfahren wird der Isolationswiderstand eines Gleichspannungseingangs eines laufenden transformatorlosen Wechselrichters, der an einem Wechselspannungsausgang mit vorgegebenem Erdbezug einen Wechselstrom ausgibt, und von an den Gleichspannungseingang angeschlossenen Gleichspannungsquellen gegenüber Erde gemessen. Dazu wird ein periodisches Prüfspannungssignal mit einer geringeren Frequenz als derjenigen des Wechselstroms so gegenüber dem vorgegebenen Erdbezug des Wechselspannungsausgangs generiert, dass es bei dem laufenden Wechselrichter auf die Spannung am Gleichspannungseingang aufmoduliert wird, und ein durch das Prüfspannungssignal hervorgerufener Erdstrom wird erfasst.

Das erfindungsgemäße Verfahren kann fortlaufend durchgeführt werden, um den Isolationswiderstand fortlaufend bei dem laufenden Wechselrichter zu messen. Ein nur vorübergehendes oder intermittierendes Messen des Isolationswiderstands bei dem laufenden Wechselrichter ist jedoch ebenso möglich.

Bei dem erfindungsgemäßen Verfahren ist der vorgegebene Erdbezug des Wechselspannungsausgangs des Wechselrichters in der Regel zumindest vorübergehend fest; jedenfalls variiert er allenfalls mit einer viel niedrigeren Frequenz als das Prüfspannungssignal. Dieser vorgegebene Erdbezug wird zur Abstützung des Prüfspannungssignals verwendet. Dies kann auf unterschiedliche Weise erfolgen.

Eine Möglichkeit, das Prüfspannungssignal so gegenüber dem vorgegebenen Erdbezug des Wechselspannungsausgangs zu generieren, dass es bei dem laufenden Wechselrichter auf die Spannung am Gleichspannungseingang aufmoduliert wird, besteht darin, das periodische Prüfspannungssignal mit einer Spannungsquelle zwischen dem Wechselspannungsausgang und seinem Erdbezug zu generieren. Es versteht sich, dass dies nur möglich ist, wenn das elektrische Potential am Wechselspannungsausgang problemlos verschoben werden kann. Dies ist nicht der Fall, wenn der Wechselspannungsausgang direkt an ein Wechselspannungsnetz mit festem Erdbezug angeschlossen ist. Wenn jedoch der Wechselspannungsausgang nur an ein grundsätzlich gegenüber Erde isoliertes internes Wechselspannungsnetz angeschlossen ist, das mit einem externen Wechselspannungsnetz über einen Transformator, d. h. ohne galvanische Kopplung, verbunden ist, und ein Erdbezug des Wechselspannungsnetzes über eine Potentialverschiebeeinrichtung möglich ist, kann das Prüfspannungssignal mit einer mit der Potentialverschiebeeinrichtung in Reihe geschalteten Spannungsquelle aufgebracht werden. Ebenso wie die Potentialverschiebung aufgrund der Potentialverschiebeeinrichtung wirkt sich dann das Prüfspannungssignal über den laufenden transformatorlosen Wechselrichter hinweg auch auf dessen Gleichspannungseingang aus. Statt einer zusätzlichen Spannungsquelle für das Prüfspannungssignal neben einer Potentialverschiebeeinrichtung kann das Prüfspannungssignal - aufmoduliert auf die Gleichspannung zur Potentialverschiebung - auch mit der Potentialverschiebeeinrichtung generiert werden.

Alternativ kann das periodische Prüfspannungssignal mit dem Wechselrichter gegenüber dem Erdbezug seines Wechselspannungsausgangs generiert werden. Dies ist bei beliebigem Erdbezug des Wechselspannungsausgangs möglich, d. h. auch bei einem Erdbezug aufgrund eines angeschlossenen Wechselspannungsnetzes. Beispielsweise wirkt sich die Ansteuerung von Schaltern einer Wechselrichterbrücke des Wechselrichters auf das elektrische Potential am Gleichspannungseingang gegenüber dem Wechselspannungsausgang aus. Von dieser Tatsache wird bei einer Ausführungsform der Erfindung aktiv Gebrauch gemacht, indem das elektrische Potential am Gleichspannungseingang gemäß dem Prüfspannungssignal gegenüber dem Wechselspannungsausgang und damit gegenüber dessen Erdbezug periodisch variiert wird. Dieser Verfahrensschritt ist durch einfache Manipulation der Steuerung bekannter Wechselrichter realisierbar, indem das Prüfspannungssignal durch Modifikation von Ansteuersignalen für die Schalter der Wechselrichterbrücke erzeugt wird. Das heißt, einem die Wechselrichterbrücke ansteuernden Prozessor braucht neben den Sollwerten für die einzelnen Ausgangswechselspannungen nur das Prüfspannungssignal als periodisches Gleichtaktsignal zugeführt zu werden. So stellt der Wechselrichter an seinem Wechselspannungsausgang die für das Prüfspannungssignal gewünschte Spannungsmodulation gegenüber dem Erdbezug ein. Diese wirkt sich dann auch auf den Gleichspannungseingang des transformatorlosen Wechselrichters aus.

Das Prüfspannungssignal weist bei dem erfindungsgemäßen Verfahren typischerweise eine Frequenz auf, die mindestens um einen Faktor 5 und häufig um einen Faktor 10 kleiner ist als die Ausgangswechselspannung des Wechselrichters. Dies bedeutet, dass die Frequenz des Prüfspannungssignals bei einer Frequenz der Ausgangswechselspannung von beispielsweise 50 oder 60 Hz maximal im Bereich weniger Hz liegt und typischerweise unter 1 Hz bis herab zu 100 mHz. Mit diesen niedrigen Frequenzen wird den großen Ableitkapazitäten von Photovoltaikgeneratoren als Gleichspannungsquellen, die an den Gleichspannungseingang angeschlossen sein können, Rechnung getragen. Das heißt, mit den niedrigen Frequenzen wird dafür gesorgt, dass der Erdstrom einen für die Messung des Isolationswiderstands ausreichend großen resistiven Anteil aufweist und nicht völlig von seinem kapazitiven Anteil dominiert wird, den die Ableitkapazitäten bestimmen.

Da sich die Ableitkapazität von Photovoltaikgeneratoren auch durch Luftfeuchtigkeit und insbesondere Niederschlag auf die Photovoltaikgeneratoren verändert, kann es sinnvoll sein, die Frequenz des Prüfspannungssignals zu varüeren. Ziel dieser Variation kann es sein, die Frequenz unter der Randbedingung, einen für die Messung des Isolationswiderstands ausreichend großen resistiven Anteil des Erdstroms zu haben, zu maximieren, um möglichst schnell Informationen über eine durch eine Störung verursachte Änderung des Isolationswidersands zu erhalten. Das heißt, bei relativ kleiner Größe der Ableitkapazitäten kann die Frequenz des Prüfspannungssignals höher eingestellt werden als bei infolge von beispielsweise Niederschlag größeren Ableitkapazitäten derselben Photovoltaikgeneratoren. Indem das Prüfspannungssignal mit dem nur geringen Innenwiderstand des Wechselrichters auf die Spannung an dessen Gleichspannungseingang aufgebracht wird, ist die Empfindlichkeit des erfindungsgemäßen Verfahrens gegenüber schwankenden Ableitkapazitäten, für die der Isolationswiderstand mit ausreichender Genauigkeit zu bestimmen ist, jedoch grundsätzlich geringer als bei bekannten Verfahren. Bei diesen bekannten Verfahren wird ein Prüfspannungssignal über Impedanzketten aufgeprägt, welche Impedanzen im zwei- bis dreistelligen Kiloohmbereich aufweisen.

Alternativ oder zusätzlich zu einer Frequenzvariation des Prüfspannungssignals ist es bei dem erfindungsgemäßen Verfahren auch möglich, die Amplitude des Prüfspannungssignals zu variieren, um einen für die Messung des Isolationswiderstands ausreichend großen Erdstrom und insbesondere einen ausreichend großen resistiven Anteil dieses Erdstroms zu erhalten. Es versteht sich jedoch, dass der relative Anteil des resistiven Erdstroms an dem gesamten Erdstrom durch Erhöhen der Amplitude des Prüfspannungssignals nicht erhöht werden kann, sondern nur seine absolute Größe.

Der durch das Prüfspannungssignal hervorgerufene Erdstrom kann grundsätzlich an dem Gleichspannungseingang des Wechselrichters erfasst werden, und zwar als Teil einer Stromsumme über alle Leitungen des Gleichspannungseingangs, die dem Gesamterdstrom entspricht. Für eine Messung der Stromsumme an dieser Stelle sind bei vielen Wechselrichtern jedoch keine Stromsensoren vorhanden, sondern müssten zusätzlich vorgesehen werden. Daher kann es bei dem erfindungsgemäßen Verfahren günstig sein, den durch das Prüfspannungssignal hervorgerufenen Erdstrom an dem Wechselspannungsausgang zu erfassen. Auch hier bildet sich der Erdstrom in der Stromsumme über alle Leitungen des Wechselspannungsausgangs ab.

Vielfach sind bei Wechselrichtern Stromsensoren in den einzelnen Leitungen des Wechselrichterausgangs vorgesehen, um die durch diese einzelnen Leitungen fließenden Phasenströme zu messen und zu überwachen. Auch die Summe dieser Phasenströme kann bei dem erfindungsgemäßen Verfahren zum Ermitteln des Isolationswiderstands verwendet werden. Bei anderen Wechselrichtern ist ein Summenstromwandler am Ausgang vorgesehen, um eine Überwachung auf Erdschlussströme durchzuführen. Das Ausgangssignal eines solchen Summenstromwandlers kann ebenfalls für die Messung des Isolationswiderstands gemäß dem erfindungsgemäßen Verfahren Verwendung finden.

Das periodische Prüfspannungssignal kann insbesondere einen sinusförmigen Verlauf aufweisen, obwohl grundsätzlich auch Prüfspannungssignale mit anderem periodischen, wie beispielsweise mit dreieckigem Verlauf verwendbar sind. Der periodische Verlauf des Prüfspannungssignals ist aber erforderlich, um den von dem Prüfspannungssignal hervorgerufenen Anteil des Gesamterdstroms bestimmen zu können.

Wenn beispielsweise in Form der Stromsumme an dem Wechselspannungsausgang ein Gesamterdstrom gemessen wird, umfasst dieser in der Regel neben dem Erdstrom, der durch das Prüfspannungssignal hervorgerufen wird, auch andere Anteile, beispielsweise mit der Frequenz der von dem Wechselrichter ausgegebenen Wechselspannung oder vielfachen davon. Diese Frequenzen sind für die Messung des Isolationswiderstands aus den oben geschilderten Gründen zu hoch, so dass die zugehörigen Anteile des Gesamterdstroms für die Ermittlung des Isolationswiderstands nicht geeignet sind.

Wenn der Gesamterdstrom mit einem Referenzsignal, das den gleichen Verlauf wie das Prüfspannungssignal aufweist, multipliziert wird und ein Gleichanteil dieses Produkts ermittelt wird, wird ein Effektivwert eines Stromanteils des durch das Prüfspannungssignal hervorgerufenen Erdstroms bestimmt. Wenn das Referenzsignal dabei mit dem Prüfspannungssignal, so wie es sich auf den Gleichspannungseingang auswirkt, in Phase ist, handelt es sich bei diesem Stromanteil um den resistiven Anteil des Erdstroms, der für die Bestimmung des Isolationswiderstands ausreichend ist. Es versteht sich, dass dieser Stromanteil nur bei einer bestimmten Amplitude des Referenzsignals den resistiven Anteil des durch das Prüfspannungssignal hervorgerufenen Erdstroms direkt angibt. Ansonsten muss mit einem Anpassungskoeffizienten, der empirisch bestimmt werden kann, eine Anpassung vorgenommen werden. Der Gleichanteil des Produkts ist in jedem Fall umgekehrt proportional zu dem gesuchten Isolationswiderstand. So kann der gesuchte Isolationswiderstand als Produkt des Kehrwerts dieses Gleichanteils und der empirisch bestimmten Proportionalitätskonstante bestimmt werden.

Zusätzlich kann der Gesamterdstrom mit einem zweiten Referenzsignal, das gegenüber dem ersten Referenzsignal um $\pi/2$ phasenversetzt ist, multipliziert werden. Dann kann ein Gleichanteil dieses Produkts ermittelt werden, um einen Effektivwert eines zweiten Stromanteils des durch das Prüfspannungssignal hervorgerufenen Erdstroms zu bestimmen. In dem bereits angesprochenen Fall, dass das erste Referenzsignal in Phase zu dem Prüfspannungssignal verläuft, entspricht der zweite Stromanteil dem kapazitiven Anteil des von dem Prüfspannungssignal hervorgerufenen Erdstroms. Damit ist der zweite Stromanteil bei fester Frequenz des Prüfspannungssignals proportional zu der Ableitkapazität des Gleichspannungseingangs und der daran angeschlossenen Gleichspannungsquellen. Auch hier lässt sich die Proportionalitätskonstante, die jedoch von der Frequenz des Prüfspannungssignals abhängig ist, leicht empirisch bestimmen.

Wenn zwischen dem ersten Referenzsignal und dem Prüfspannungssignal eine Verschiebung in Bezug auf Amplitude und/oder Phase nicht ausgeschlossen werden kann, erweist es sich als sinnvoll, zusätzlich die an dem Gleichspannungseingang gegenüber Erde anliegende Gesamtspannung zu messen und mit dem ersten Referenzsignal zu multiplizieren und einen Gleichanteil dieses Produkts zu ermitteln, um einen Effektivwert eines ersten Spannungsanteils des Prüfspannungssignals zu bestimmen. Bei der an dem Gleichspannungseingang anliegenden Gesamtspannung handelt es sich um die Spannung des Potentialmittelpunkts des Gleichspannungseingangs gegenüber Erde, die auch als Nullsystemspannung bezeichnet wird und die als Mittelwert der Spannungen an den beiden Leitungen des Gleichspannungseingangs gegenüber Erde bestimmt werden kann.

Neben dem ersten Spannungsanteil des Prüfspannungssignals in Phase mit dem ersten Referenzsignal wird dann noch ein Spannungsanteil mit einem Phasenversatz von $\pi/2$ des Prüfspannungssignals bestimmt, indem die Gesamtspannung mit dem zweiten Referenzsignal multipliziert wird und ein Gleichanteil dieses Produkts ermittelt wird.

Insgesamt wird damit das an dem Gleichspannungseingang anliegende Prüfspannungssignal in Form von zwei orthogonalen Komponenten erfasst. Zusammen mit den beiden orthogonalen Komponenten des durch das Prüfspannungssignal hervorgerufenen Erdstroms liegt dann eine vollständige Grundlage für die Berechnung des Isolationswiderstands und auch der Ableitkapazität vor.

So können ein Quadrat des Effektivwerts des ersten Spannungsanteils und ein Quadrat des Effektivwerts des zweiten Spannungsanteils addiert werden, um ein Quadrat eines Effektivwerts des Prüfspannungssignals zu erhalten. Dann können ein erstes Produkt aus dem Effektivwert des ersten Stromanteils und dem Effektivwert des ersten Spannungsanteils und ein zweites Produkt aus dem Effektivwert des zweiten Stromanteils und dem Effektivwert des zweiten Spannungsanteils addiert werden, um eine virtuelle Wirkleistung zu erhalten. Wenn dann das Quadrat des Effektivwerts des Prüfspannungssignals durch die virtuelle Wirkleistung dividiert wird, erhält man den Isolationswiderstand, zumindest bis auf einen konstanten Anpassungskoeffizienten, der empirisch ermittelbar ist.

Die Ableitkapazität ergibt sich demgegenüber als Quotient aus einer virtuellen Blindleistung und dem Quadrat des Effektivwerts des Prüfspannungssignals, wobei hier ein Proportionalitätsfaktor von der Frequenz des Prüfsignals abhängig ist. Die virtuelle Blindleistung lässt sich als Differenz zwischen einem dritten Produkt aus dem Effektivwert des ersten Spannungsanteils und dem Effektivwert des zweiten Stromanteils einerseits und einem vierten Produkt aus dem Effektivwert des zweiten Spannungsanteils und dem Effektivwert des ersten Stromanteils andererseits berechnen.

Vorteilhafte Weiterbildungen der Erfindung ergeben sich aus den Patentansprüchen, der Beschreibung und den Zeichnungen. Die in der Beschreibung genannten Vorteile von Merkmalen und von Kombinationen mehrerer Merkmale sind lediglich beispielhaft und können alternativ oder kumulativ zur Wirkung kommen, ohne dass die Vorteile zwingend von erfindungsgemäßen Ausführungsformen erzielt werden müssen. Ohne dass hierdurch der Gegenstand der beigefügten Patentansprüche verändert wird, gilt hinsichtlich des Offenbarungsgehalts der ursprünglichen Anmeldungsunterlagen und des Patents Folgendes: weitere Merkmale sind den Zeichnungen zu entnehmen. Die Kombination von Merkmalen unterschiedlicher Ausführungsformen der Erfindung oder von Merkmalen unterschiedlicher Patentansprüche ist ebenfalls abweichend von den gewählten Rückbeziehungen der Patentansprüche möglich und wird hiermit angeregt. Dies betrifft auch solche Merkmale, die in separaten Zeichnungen dargestellt sind oder bei deren Beschreibung genannt werden. Diese Merkmale können auch mit Merkmalen unterschiedlicher Patentansprüche kombiniert werden. Ebenso können in den Patentansprüchen aufgeführte Merkmale für weitere Ausführungsformen der Erfindung entfallen.

Die in den Patentansprüchen und der Beschreibung genannten Merkmale sind bezüglich ihrer Anzahl so zu verstehen, dass genau diese Anzahl oder eine größere Anzahl als die genannte Anzahl vorhanden ist, ohne dass es einer expliziten Verwendung des Adverbs "mindestens" bedarf. Wenn also beispielsweise von einem Element die Rede ist, ist dies so zu verstehen, dass genau ein Element, zwei Elemente oder mehr Elemente vorhanden sind. Diese Merkmale können durch andere Merkmale ergänzt werden oder die einzigen Merkmale sein, aus denen das jeweilige Erzeugnis besteht.

Die in den Patentansprüchen enthaltenen Bezugszeichen stellen keine Beschränkung des Umfangs der durch die Patentansprüche geschützten Gegenstände dar. Sie dienen lediglich dem Zweck, die Patentansprüche leichter verständlich zu machen.

## KURZBESCHREIBUNG DER FIGUREN

Im Folgenden wird die Erfindung anhand in den Figuren dargestellter bevorzugter Ausführungsbeispiele weiter erläutert und beschrieben.

Fig. 1    zeigt einen Wechselrichter mit einem dreiphasigen Wechselspannungsausgang, der an ein geerdetes Wechselspannungsnetz angeschlossen ist, wobei eine Gesamterdstromberechnung aus Phasenströmen angedeutet ist.

Fig. 2    zeigt einen Wechselrichter wie in Fig. 1, wobei eine Gesamterdstrommessung mit einem Summenstromwandler angedeutet ist.

Fig. 3      zeigt einen Wechselrichter mit einem einphasigen Wechselspannungsausgang, der an ein geerdetes Wechselspannungsnetz angeschlossen ist, wobei wieder eine Gesamterdstromberechnung aus Phasenströmen angedeutet ist.

Fig. 4      ist ein Ersatzschaltbild für den Erdstrompfad eines der Wechselrichter gemäß den Fig. 1 bis 3.

Fig. 5      stellt eine erste Ausführungsform eines erfindungsgemäßen Auswertungsverfahrens für den an dem Wechselrichter gemäß Fig. 1 gemessenen Gesamterdstrom dar; und

Fig. 6      stellt eine andere Ausführungsform eines erfindungsgemäßen Auswertungsverfahrens für den an dem Wechselrichter gemäß Fig. 1 gemessenen Gesamterdstrom dar.

**FIGURENBESCHREIBUNG**

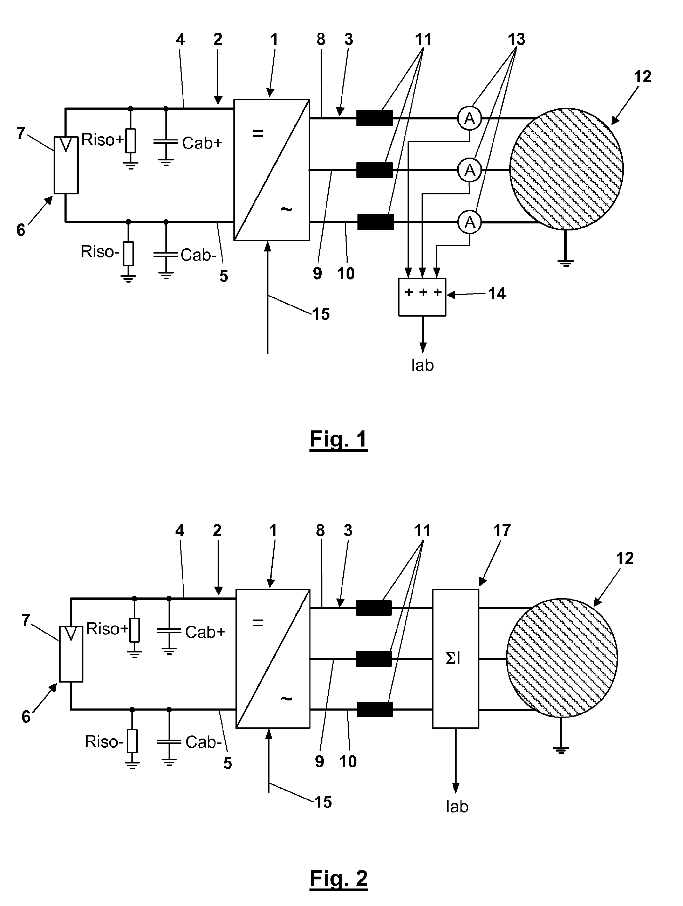

In **Fig. 1** ist schematisch ein Wechselrichter 1 mit einem Gleichspannungseingang 2 und einem Wechselspannungsausgang 3 dargestellt. Der Gleichspannungseingang 2 umfasst eine Leitung 4 zum Anschluss eines positiven Pols und eine Leitung 5 zum Anschluss eines negativen Pols einer Gleichspannungsquelle 6. Hier ist die Gleichspannungsquelle 6 als Photovoltaikgenerator 7 angedeutet. Der Wechselspannungsausgang 3 des Wechselrichters 1 ist dreiphasig und umfasst drei Leitungen 8 bis 10 für die einzelnen Phasen, die entsprechend auch als Phasenleiter bezeichnet werden. In den Leitungen 8 bis 10 sind Glättungsdrosseln 11 vorgesehen. Über die Glättungsdrosseln 11 sind die Leitungen 8 bis 10 an die entsprechenden Phasen eines geerdeten Wechselspannungsnetzes 12 angeschlossen. Dabei werden die von dem Wechselrichter durch die einzelnen Leitungen 8 bis 10 fließenden Phasenströme mit Strommesseinrichtungen 13 gemessen.

Der Gleichspannungseingang 2 des Wechselrichters 1 ist ebenso wie die daran angeschlossene Gleichspannungsquelle 6 als solcher/solche gegenüber Erde isoliert. Dennoch tritt insbesondere bei großflächigen Photovoltaikgeneratoren 7 eine Wechselwirkung zur Erde auf, die hier durch Isolationsteilwiderstände Riso+ und Riso- sowie Ableitteilkapazitäten Cab+ und Cab- zeichnerisch angedeutet sind. Diese Isolationsteilwiderstände und Ableitteilkapazitäten führen allein aufgrund der an dem Gleichspannungseingang 2 anliegenden Ausgangsspannung der Gleichspannungsquelle 6 zu Erdströmen, die durch einen Stromrückfluss von der Erde des Wechselspannungsnetzes 12 ausgeglichen werden. Diese Erdströme finden sich in der Summe der mit den Strommesseinrichtungen 13 gemessenen Ströme, d. h. einer Stromsumme über den Wechselspannungsausgang 3 wieder. Konkret bildet die mit einem Addierer 14 ermittelte Stromsumme den insgesamt fließenden Gesamterdstrom Iab ab.

Zur Ermittlung des Isolationswiderstands des Gleichspannungseingangs 2 und der daran angeschlossenen Gleichspannungsquelle 6 wird ein Ansteuersignal 15 für den Wechselstroms so moduliert, dass es gemäß einem periodischen Prüfspannungssignal zu einer periodischen Verschiebung des elektrischen Potentials am Gleichspannungseingang 2 gegenüber Erde kommt. Dabei ist die Frequenz des Prüfspannungssignals deutlich kleiner als diejenige des sich aus den Phasenströmen zusammensetzenden Wechselstroms, den der Wechselrichter 1 an seinem Wechselspannungsausgang 3 ausgibt. Beim Erzeugen der periodischen Potentialverschiebung am Gleichspannungseingang 2 gemäß dem Prüfspannungssignal 16 stützt sich der Wechselrichter 1 an dem Erdbezug seines Wechselspannungsausgangs 3 ab. Dieser Erdbezug ist über die Erdung des direkt, d. h. ohne galvanische Entkopplung, an den Wechselspannungsausgang 3 angeschlossenen geerdeten Wechselspannungsnetzes 12 gegeben. Der interessierende Isolationswiderstand des Gleichspannungseingangs 2 ist der Quotient aus dem Prüfspannungssignal 16 und dem Anteil des Gesamterdstroms Iab, der durch das Prüfspannungssignal 16 hervorgerufen wird und mit der entsprechenden Potentialverschiebung am Gleichspannungseingang 2 in Phase ist. Demgegenüber kann die Ableitkapazität aus dem durch das Prüfspannungssignal 16 hervorgerufenen Anteil des Gesamterdstroms Iab bestimmt werden, der um $\pi/2$ phasenversetzt gegenüber der periodischen Potentialverschiebung am Gleichspannungseingang 2 ist.

**Fig. 2** zeigt einen Wechselrichter 1 in einer grundsätzlich Fig. 1 entsprechenden Anordnung und Verschaltung. Hier ist jedoch statt der einzelnen Strommesseinrichtungen 13 und des Addierers 14 ein Summenstromwandler 17 vorgesehen, durch den alle Leitungen 8 bis 10 hindurch verlaufen und der direkt den Gesamterdstrom Iab als Stromsumme über diese Leitungen 8 bis 10 ausgibt.

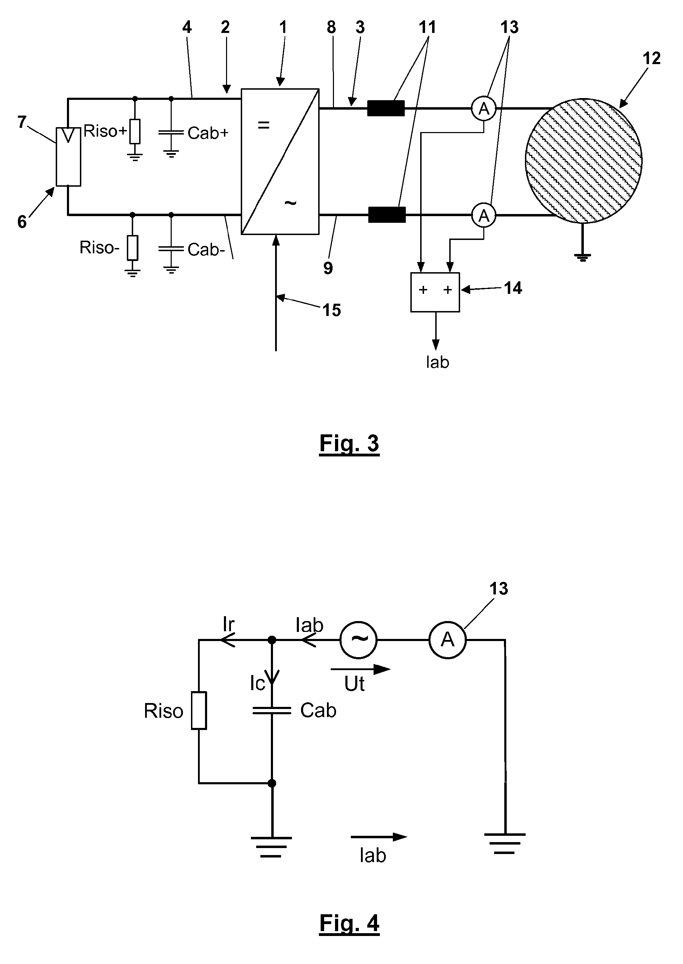

**Fig. 3** zeigt einen Wechselrichter 1, der sich von dem Wechselrichter 1 gemäß Fig. 1 dadurch unterscheidet, dass sein Wechselspannungsausgang 3 einphasig ist und entsprechend nur zwei Leitungen 8 und 9 umfasst. Entsprechend wird hier die Stromsumme über den Wechselspannungsausgang 3 von dem Addierer 14 nur durch Addieren der mit zwei Strommesseinrichtungen 13 gemessenen Phasenströme ermittelt.

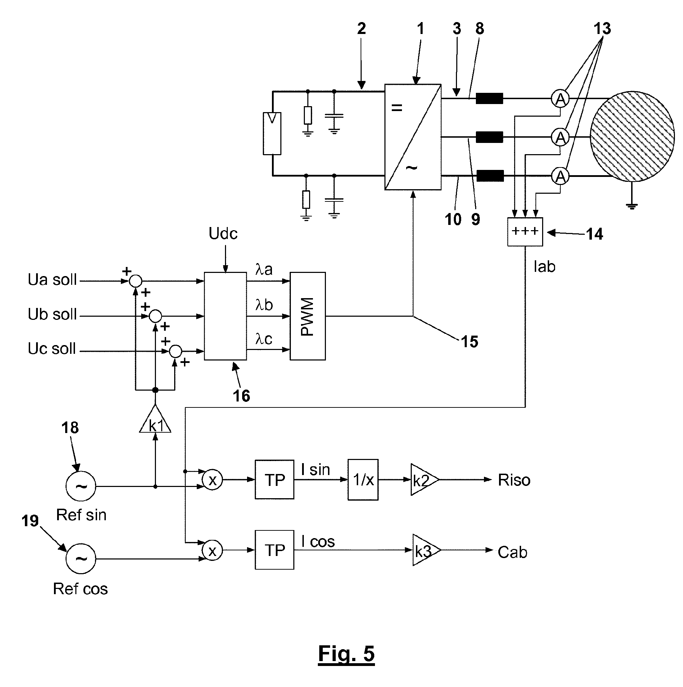

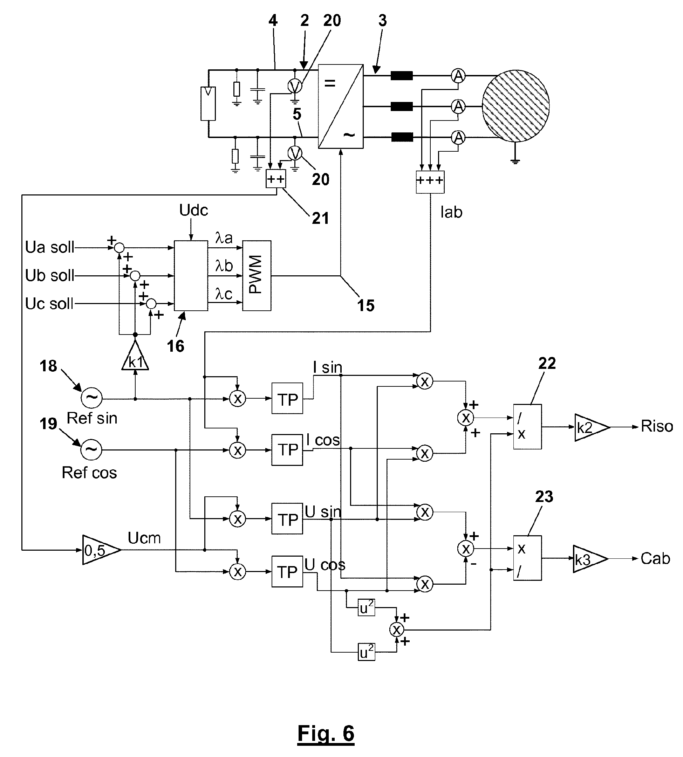

**Fig. 4** ist ein Ersatzschaltbild für den Erdstrompfad eines der Wechselrichter 1 gemäß den Fig. 1 bis 3. Aufgrund des Prüfspannungssignals Ut, des begrenzten Isolationswiderstands Riso und der Ableitkapazität Cab fließt ein Gesamtstrom Iab mit einem resistiven Anteil Ir über den Isolationswiderstand Riso und einem kapazitiven Anteil Ic über die Ableitkapazität Cab. Der Gesamterdstrom Iab wird mit der Strommesseinrichtung 13 gemessen, und durch die Relation seiner Anteile zu dem Prüfspannungssignal Ut lassen sich sowohl der Isolationswiderstand Riso als auch die Ableitkapazität Cab bestimmen. Konkrete mögliche Ausführungsformen dieser Bestimmung sind in den folgenden Fig. 5 und 6 zeichnerisch dargestellt.

In **Fig. 5** ist ausgehend von dem Wechselrichter 1 gemäß Fig. 1 dargestellt, wie der Wechselrichter 1 angesteuert wird, um das Prüfspannungssignal zu erzeugen, und wie der Gesamterdstrom Iab bezüglich seiner durch das Prüfspannungssignal hervorgerufenen Anteile ausgewertet wird. Ein erstes Referenzsignal 18 wird mit sinusförmigem Verlauf und der gewünschten Frequenz des Prüfspannungssignals bereitgestellt. Dieses erste Referenzsignal 18 wird mit einem Anpassungskoeffizienten k1 skaliert und auf die Sollspannungen Ua soll, Ub soll und Uc soll für die an den Leitungen 8 bis 10 des Wechselspannungsausgangs 3 anstehenden Spannungen gegenüber Erde aufmoduliert. Entsprechend wird das Ansteuersignal 15 für den Wechselrichter 1 zur Erfüllung dieser Anforderungen durch Pulsweitenmodulation bei der Ansteuerung seiner Schalter erzeugt.

Ein Prozessor 16, der aus den Werten von Ua soll, Ub soll und Uc soll mit dem aufmodulierten skalierten Referenzsignal 18 Aussteuergrade λa, λb und λc bestimmt, die von einer Pulsweitenmodulation PWM in das Ansteuersignal 15 umgesetzt werden, berücksichtigt dabei auch einen Sollwert Udc für eine Potentialverschiebung am Gleichspannungseingang 2 gegenüber dem Erdbezug des Wechselspannungsausgangs 3.

Das Referenzsignal 18 wird zudem mit dem Gesamterdstrom Iab multipliziert und anschließend tiefpassgefiltert, um einen Effektivwert Isin eines ersten Stromanteils des durch das Prüfspannungssignal hervorgerufenen Erdstroms zu ermitteln. Hiervon wird ein Kehrwert gebildet, und nach Multiplikation mit einem empirisch bestimmten Anpassungskoeffizienten k2 ergibt sich unmittelbar der interessierende Isolationswiderstand Riso.

Ein zweites Referenzsignal 19, das gegenüber dem sinusförmigen Referenzsignal 18 einen Phasenversatz von π/2 aufweist bezeichnet wird, wird ebenfalls mit dem Gesamterdstrom Iab multipliziert. Eine anschließende Tiefpassfilterung ergibt einen Effektivwert Icos eines zweiten Stromanteils des durch das Prüfspannungssignal hervorgerufenen Erdstroms, der mit einem Skalierungsfaktor k3 multipliziert der gesuchten Ableitkapazität Cab entspricht. Bei der Vorgehensweise gemäß Fig. 5 ist unterstellt, dass das Prüfspannungssignal, mit dem die periodische Potentialverschiebung am Gleichspannungseingang 2 des Wechselrichters 1 hervorgerufen wird, in Phase mit dem Referenzsignal 18 ist. Wenn hier jedoch Phasenverschiebungen oder Amplitudenabweichungen auftreten, müssen diese berücksichtigt werden.

Dies geschieht bei der in **Fig. 6** skizzierten Vorgehensweise. Dazu sind zusätzliche Spannungsmesseinrichtungen 20 vorgesehen, die die Spannungen an den Leitungen 4 und 5 des Gleichspannungseingangs 2 gegenüber Erde messen. Diese Spannungen werden mit einem Addierer 21 aufaddiert und anschließend durch 2 geteilt, um den Potentialverlauf am Gleichspannungseingang 2 gegenüber Erde als Potentialverlauf des Potentialmittelpunkts zwischen den beiden Leitungen 4 und 5 abzubilden. Dieses Spannungssignal Ucm wird dann einerseits mit dem ersten Referenzsignal 18 und andererseits mit dem dazu um π/2 phasenversetzten zweiten Referenzsignal 19 multipliziert, um die beiden orthogonalen Anteile des Prüfspannungssignals, das dieselbe Frequenz wie das Referenzsignal 18 aufweist, zu ermitteln. Tiefpassfilterung zur Mittelung ergibt den Effektivwert Usin des Spannungsanteils des Prüfspannungssignals, der sich mit dem Referenzsignal 18 in Phase befindet, und den Effektivwert Ucos des Anteils des Prüfspannungssignals, der mit dem Referenzsignal 19 in Phase ist und entsprechend einen Phasenversatz von π/2 zu dem Referenzsignal 18 aufweist. Die beiden Effektivwerte Usin und Ucos werden quadriert, und ihre Quadrate werden anschließend addiert, um das Quadrat $Urms^2$ der effektiven Signalspannung zu berechnen:

$$Urms^2 = Usin^2 + Ucos^2.$$

Weiterhin werden die Effektivwerte Isin und Icos mit jeweils einem der Effektivwerte Usin und Ucos multipliziert und die so erhaltenen Produkte wie folgt addiert, um eine virtuelle Wirkleistung $P^*$ und eine virtuelle Blindleistung $Q^*$ zu berechnen:

$$P^* = Ucos \cdot Icos + Usin \cdot Isin$$

$$Q^* = Usin \cdot Icos - Ucos \cdot Isin.$$

Aus diesen Werten lässt sich dann mit Hilfe von zwei Dividierern 22 und 23, wobei die Ausgangswerte noch mit Skalierungsfaktoren k2 bzw. k3 multipliziert werden, der gesuchte Isolationswiderstand Riso sowie die Ableitkapazität Cab bestimmen:

$$Riso = k2 \cdot Urms^2/P^*$$

$$Cab = k3 \cdot Q^*/Urms^2.$$

Der Anpassungskoeffizient k2 hängt von dem Anpassungskoeffizienten k1 und den wirksamen Übertragungsfunktionen ab. Er kann im Idealfall 1 sein. Der Anpassungskoeffizient k3 hingegen ist zusätzlich frequenzabgängig, d. h. er variiert zusätzlich mit der Frequenz des Referenzsignals 18 bzw. des Prüfspannungssignals. Der Anpassungskoeffizient k1 kann geeignet festgelegt werden, und die daraus resultierenden Anpassungskoeffizienten k2 und k3 (für eine bestimmte Frequenz des Referenzsignals 18) können empirisch, aber auch analytisch ermittelt werden.

**BEZUGSZEICHENLISTE**

| | |
|---|---|
| 1 | Wechselrichter |
| 2 | Gleichspannungseingang |
| 3 | Wechselspannungsausgang |
| 4 | Leitung |
| 5 | Leitung |
| 6 | Gleichspannungsquelle |
| 7 | Photovoltaikgenerator |
| 8 | Leitung |
| 9 | Leitung |
| 10 | Leitung |
| 11 | Glättungsdrossel |
| 12 | Wechselspannungsnetz |
| 13 | Strommesseinrichtung |
| 14 | Addierer |
| 15 | Ansteuersignal |
| 16 | Prozessor |
| 17 | Summenstromwandler |
| 18 | erstes Referenzsignal |
| 19 | zweites Referenzsignal |
| 20 | Spannungsmesseinrichtung |
| 21 | Addierer |
| 22 | Dividierer |
| 23 | Dividierer |
| Riso | Isolationswiderstand |
| Riso+, Riso- | Komponenten des Isolationswiderstands |
| Cab | Ableitkapazität |
| Cab+, Cab- | Komponenten der Ableitkapazität |
| $\lambda a$ | Aussteuergrad für die Schalter des Wechselrichters 1 zur Leitung 8 |
| $\lambda b$ | Aussteuergrad für die Schalter des Wechselrichters 1 zur Leitung 9 |
| $\lambda c$ | Aussteuergrad für die Schalter des Wechselrichters 1 zur Leitung 10 |
| PWM | Pulsweitenmodulation |
| k1 | Anpassungskoeffizient |
| k2 | Anpassungskoeffizient |
| k3 | Anpassungskoeffizient |
| TP | Tiefpassfilter |
| Iab | Gesamterdstrom |
| Ir | resistiver Anteil von Iab |
| Ic | kapazitiver Anteil von Iab |
| Isin | Effektivwert einer Komponente von Iab |
| Icos | Effektivwert einer Komponente von Iab |
| Ua soll | Sollwert für Wechselspannung an Leitung 8 |
| Ub soll | Sollwert für Wechselspannung an Leitung 9 |
| Uc soll | Sollwert für Wechselspannung an Leitung 10 |
| Udc | Sollwert für feste Potentialverschiebung am Gleichspannungseingang 2 gegenüber dem Erdbezug des Wechselspannungsausgangs 3 |
| Ucm | Gesamtspannung am Potentialmittelpunkt des Gleichspannungseingangs 2 gegenüber Erde |
| Usin | Effektivwert einer Komponente von Ucm |
| Ucos | Effektivwert einer Komponente von Ucm |
| Ut | Prüfspannungssignal |

**Patentansprüche**

1. Verfahren zur Messung des Isolationswiderstands (Riso) eines Gleichspannungseingangs (2) eines laufenden transformatorlosen Wechselrichters (1) und von an den Gleichspannungseingang (2) angeschlossenen Gleichspannungsquellen (6) gegenüber Erde,

    - wobei ein periodisches Prüfspannungssignal (Ut) mit einer geringeren Frequenz als derjenigen eines Wechselstroms, den der laufende Wechselrichter (1) an seinem Wechselspannungsausgang (3) ausgibt, auf die Spannung am Gleichspannungseingang (2) aufmoduliert wird, und
    - wobei ein durch das Prüfspannungssignal (Ut) hervorgerufener Erdstrom erfasst wird,

    **dadurch gekennzeichnet, dass** das Prüfspannungssignal (Ut) so gegenüber einem vorgegebenen Erdbezug des Wechselspannungsausgangs (3) generiert wird, dass es bei dem laufendem Wechselrichter (1) auf die Spannung an dessen Gleichspannungseingang (2) aufmoduliert wird.

2. Verfahren nach Anspruch 1, **dadurch gekennzeichnet, dass** das periodische Prüfspannungssignal (Ut) mit einer Spannungsquelle zwischen dem Wechselspannungsausgang (3) und seinem Erdbezug generiert wird.

3. Verfahren nach Anspruch 1, **dadurch gekennzeichnet, dass** das periodische Prüfspannungssignal (Ut) mit dem Wechselrichter (1) gegenüber dem Erdbezug seines Wechselspannungsausgangs (3) generiert wird.

4. Verfahren nach Anspruch 3, **dadurch gekennzeichnet, dass** das Prüfspannungssignal (Ut) durch Modifikation von Ansteuersignalen für eine Wechselrichterbrücke des Wechselrichters (1) erzeugt wird.

5. Verfahren nach einem der vorhergehenden Ansprüche, **dadurch gekennzeichnet, dass** das Prüfspannungssignal (Ut) eine Frequenz aufweist, die mindestens um einen Faktor 5 und häufig um einen Faktor 10 kleiner ist als diejenige des Wechselstroms, die der laufende Wechselrichter (1) an seinem Wechselspannungsausgang (3) ausgibt.

6. Verfahren nach einem der vorhergehenden Ansprüche, **dadurch gekennzeichnet, dass** die Frequenz des Prüfspannungssignals (Ut) und/oder eine Amplitude des Prüfspannungssignals (Ut) variiert wird.

7. Verfahren nach einem der vorhergehenden Ansprüche, **dadurch gekennzeichnet, dass** der durch das Prüfspannungssignal (Ut) hervorgerufene Erdstrom an dem Wechselspannungsausgang (3) erfasst wird.

8. Verfahren nach Anspruch 7, **dadurch gekennzeichnet, dass** der Erdstrom als Teil einer Stromsumme über dem Wechselspannungsausgang (3) erfasst wird.

9. Verfahren nach Anspruch 8, **dadurch gekennzeichnet, dass** die Stromsumme mit einem Summenstromwandler (17) oder durch Messen der Ströme durch einzelne Leitungen (8 bis 10) und Aufsummieren dieser Ströme erfasst wird.

10. Verfahren nach einem der vorhergehenden Ansprüche, **dadurch gekennzeichnet, dass** das Prüfspannungssignal (Ut) einen sinusförmigen Verlauf aufweist.

11. Verfahren nach einem der vorhergehenden Ansprüche, **dadurch gekennzeichnet, dass** ein Gesamterdstrom (Iab) gemessen und mit einem ersten Referenzsignal (18), das den gleichen Verlauf wie das Prüfspannungssignal (Ut) aufweist, multipliziert wird und ein Gleichanteil dieses Produkts ermittelt wird, um einen Effektivwert (Isin) eines ersten Stromanteils des durch das Prüfspannungssignal (Ut) hervorgerufenen Erdstroms zu bestimmen.

12. Verfahren nach Anspruch 11, **dadurch gekennzeichnet, dass** der Gesamterdstrom (Iab) mit einem zweiten Referenzsignal (19), das gegenüber dem ersten Referenzsignal (18) um $\pi/2$ phasenversetzt ist, multipliziert wird und ein Gleichanteil dieses Produkts ermittelt wird, um einen Effektivwert (Icos) eines zweiten Stromanteils des durch das Prüfspannungssignal (Ut) hervorgerufenen Erdstroms zu bestimmen.

13. Verfahren nach Anspruch 11 oder 12, **dadurch gekennzeichnet, dass** eine an dem Gleichspannungseingang gegenüber Erde anliegende Gesamtspannung (Ucm) gemessen und mit dem ersten Referenzsignal (18) multipliziert wird und ein Gleichanteil dieses Produkts ermittelt wird, um einen Effektivwert (Usin) eines ersten Spannungsanteils des Prüfspannungssignals (Ut) zu bestimmen.

14. Verfahren nach Anspruch 12 und Anspruch 13, **dadurch gekennzeichnet, dass** die Gesamtspannung (Ucm) mit dem zweiten Referenzsignal (19) multipliziert wird und ein Gleichanteil dieses Produkts ermittelt wird, um einen Effektivwert (Ucos) eines zweiten Spannungsanteils des Prüfspannungssignals (Ut) zu bestimmen.

15. Verfahren nach Anspruch 14, **dadurch gekennzeichnet, dass** ein Quadrat des Effektivwerts (Usin) des ersten Spannungsanteils und ein Quadrat des Effektivwerts (Ucos) des zweiten Spannungsanteils addiert werden, um ein Quadrat eines Effektivwerts (Urms) des Prüfspannungssignals zu erhalten, dass ein erstes Produkt aus dem Effektivwert (Isin) des ersten Stromanteils und dem Effektivwert (Usin) des ersten Spannungsanteils und ein zweites Produkt aus dem Effektivwert (Icos) des zweiten Stromanteils und dem Effektivwert (Ucos) des zweiten Spannungsanteils addiert werden, um eine virtuelle Wirkleistung ($P^*$) zu erhalten, und dass das Quadrat des Effektivwerts (Urms) des Prüfspannungssignals durch die virtuelle Wirkleistung ($P^*$) dividiert wird, um den Isolationswiderstand (Riso) zu bestimmen.

## Claims

1. A method for measuring the insulation resistance (Riso) with respect to ground of a DC voltage input (2) of a running transformerless inverter (1) and of DC voltage sources (6) connected to the DC voltage input (2),

    - wherein a periodic test voltage signal (Ut) with a lower frequency than that of an alternating current that is emitted by the running inverter (1) at its AC voltage output (3) is modulated onto the voltage at the DC voltage input (2), and
    - wherein a ground current induced by the test voltage signal (Ut) is determined,

    **characterized in that** the test voltage signal (Ut) is generated in such a way with respect to a given ground reference of the AC voltage output (3) that it is modulated onto the voltage at the DC voltage input (2) while the inverter (1) is running.

2. The method according to claim 1, **characterized in that** the periodic test voltage signal (Ut) is generated by a voltage source between the AC voltage output (3) and its ground reference.

3. The method according to claim 1, **characterized in**

**that** the periodic test voltage signal (Ut) is generated by the inverter (1) as against the ground reference of its AC voltage output (3).

4. The method according to claim 3, **characterized in that** the test voltage signal (Ut) is generated by modifying drive signals for an inverter bridge of the inverter (1).

5. The method according to any one of the preceding claims, **characterized in that** the test voltage signal (Ut) has a frequency that is smaller by at least a factor of 5, and frequently by a factor of 10 than that of the alternating current that is emitted by the running inverter (1) at its AC voltage output (3).

6. The method according to any one of the preceding claims, **characterized in that** the frequency of test voltage signal (Ut) and/or an amplitude of the test voltage signal (Ut) is varied.

7. The method according to any one preceding claim, **characterized in that** the ground current induced by the test voltage signal (Ut) is determined at the AC voltage output (3).

8. The method according to claim 7, **characterized in that** the ground current is determined as part of a current sum across the AC voltage output (3).

9. The method according to claim 8, **characterized in that** the current sum is determined with a summation current transformer (17) or by measuring the currents through individual lines (8 to 10) and summing up these currents.

10. The method according to any one of the preceding claims, **characterized in that** the test voltage signal (Ut) has a sinusoidal course.

11. The method according to any one of the preceding claims, **characterized in that** a total ground current (Iab) is measured and is multiplied by a first reference signal (18) that has the same course as the test voltage signal (Ut), and that a DC component of this product is determined, in order to determine an rms value (Isin) of a first current component of the ground current induced by the test voltage signal (Ut).

12. The method according to claim 11, **characterized in that** the total ground current (Iab) is multiplied by a second reference signal (19) that is phase shifted relative to the first reference signal (18) by $\pi/2$, and that a DC component of this product is determined, in order to determine an rms value (Icos) of a second current component of the ground current induced by the test voltage signal (Ut).

13. The method according to claim 11 or 12, **characterized in that** a total voltage (Ucm) that is present at the DC voltage input with respect to ground is measured and is multiplied by the first reference signal (18), and that a DC component of this product is determined, in order to determine an rms value (Usin) of a first voltage component of the test voltage signal (Ut).

14. The method according to claim 12 and claim 13, **characterized in that** the total voltage (Ucm), is multiplied by the second reference signal (19), and that a DC component of this product is determined, in order to determine an rms value (Ucos) of a second voltage component of the test voltage signal (Ut).

15. The method according to claim 14, **characterized in that** a square of the rms value (Usin) of the first voltage component and a square of the rms value (Ucos) of the second voltage component are added, in order to obtain a square of an rms value (Urms) of the test voltage signal, that a first product of the rms value (Isin) of the first current component and the rms value (Usin) of the first voltage component and a second product of the rms value (Icos) of the second current component and the rms value (Ucos) of the second voltage component are added, in order to obtain a virtual active power (P*), and that the square of the rms value (Urms) of the test voltage signal is divided by the virtual active power (P*), in order to determine the insulation resistance (Riso).

**Revendications**

1. Procédé destiné à mesurer la résistance d'isolation (Riso) à la terre d'une entrée (2) de tension continue d'un onduleur (1) en service dénué de transformateur et de sources (6) de tension continue raccordées sur l'entrée (2) de tension continue,

   - un signal (Ut) périodique de tension d'essai avec une fréquence inférieure à celle d'un courant alternatif que l'onduleur (1) en service délivre sur sa sortie (3) de tension alternative étant modulé sur la tension à l'entrée (2) de tension continue et
   - un courant de fuite à la terre induit par le signal (Ut) de tension d'essai étant détecté,

   **caractérisé en ce que** le signal (Ut) de tension d'essai est généré par rapport à une mise à la terre prédéfinie de la sortie (3) de tension alternative, de sorte que lorsque l'onduleur (1) est en service, il soit modulé sur la tension sur l'entrée (2) de tension continue de celui-ci.

2. Procédé selon la revendication 1, **caractérisé en ce**

**que** le signal (Ut) périodique de tension d'essai est généré par une source de tension entre la sortie (3) de tension alternative et sa mise à la terre.

3. Procédé selon la revendication 1, **caractérisé en ce que** le signal (Ut) périodique de tension d'essai est généré avec l'onduleur (1) par rapport à la mise à la terre de sa sortie (3) de tension alternative.

4. Procédé selon la revendication 3, **caractérisé en ce que** le signal (Ut) de tension d'essai est généré par modification de signaux d'amorçage pour un pont onduleur de l'onduleur (1).

5. Procédé selon l'une quelconque des revendications précédentes, **caractérisé en ce que** le signal (Ut) de tension d'essai présente une fréquence, qui est inférieure d'au moins un coefficient 5 et souvent d'un coefficient 10 à celle du courant alternatif que l'onduleur (1) en service délivre sur sa sortie (3) de tension alternative.

6. Procédé selon l'une quelconque des revendications précédentes, **caractérisé en ce qu'**on fait varier la fréquence du signal (Ut) de tension d'essai et/ou une amplitude du signal (Ut) de tension d'essai.

7. Procédé selon l'une quelconque des revendications précédentes, **caractérisé en ce que** le courant de fuite à la terre induit par le signal (Ut) de tension d'essai est détecté sur la sortie (3) de tension alternative.

8. Procédé selon la revendication 7, **caractérisé en ce que** le courant de fuite à la terre est détecté en tant que partie d'un courant cumulé via la sortie (3) de tension alternative.

9. Procédé selon la revendication 8, **caractérisé en ce que** le courant cumulé est détecté par un convertisseur de courant cumulé (17) ou par mesure des courants à travers des conduits (8 à 10) individuels et par cumul desdits courants.

10. Procédé selon l'une quelconque des revendications précédentes, **caractérisé en ce que** le signal (Ut) de tension d'essai présente une courbe sinusoïdale.

11. Procédé selon l'une quelconque des revendications précédentes, **caractérisé en ce qu'**un courant de fuite à la terre cumulé (Iab) est mesuré et multiplié par un premier signal de référence (18) qui présente la même courbe que le signal (Ut) de tension d'essai et une composante continue dudit produit est déterminée, pour déterminer une valeur effective (Isin) d'une première composante de courant du courant de fuite à la terre induit par le signal (Ut) de tension d'essai.

12. Procédé selon la revendication 11, **caractérisé en ce que** le courant de fuite à la terre cumulé (Iab) est multiplié par un deuxième signal de référence (19), qui par rapport au premier signal de référence (18) présente un décalage de phase de n/2 et une composante continue dudit produit est déterminée, pour déterminer une valeur effective (Icos) d'une deuxième composante de courant du courant de fuite à la terre induit par le signal (Ut) de tension d'essai.

13. Procédé selon la revendication 11 ou la revendication 12, **caractérisé en ce qu'**une tension globale (Ucm) appliquée sur l'entrée de tension continue par rapport à la terre est mesurée et multipliée par le premier signal de référence (18) et une composante continue dudit produit est déterminée, pour déterminer une valeur effective (Usin) d'une première composante de tension du signal (Ut) de tension d'essai.

14. Procédé selon la revendication 12 et la revendication 13, **caractérisé en ce que** la tension globale (Ucm) est multipliée par le deuxième signal de référence (19) et une composante continue dudit produit est déterminée, pour déterminer une valeur effective (Ucos) d'une deuxième composante de tension du signal (Ut) de tension d'essai.

15. Procédé selon la revendication 14, **caractérisé en ce qu'**une puissance carrée de la valeur effective (Usin) de la première composante de tension et une puissance carrée de la valeur effective (Ucos) de la deuxième composante de tension sont additionnées, pour obtenir une puissance carrée d'une valeur effective (Urms) du signal de tension d'essai, **en ce qu'**il est additionné un premier produit de la valeur effective (Isin) de la première composante de courant et de la valeur effective (Usin) de la première composante de tension et un deuxième produit de la valeur effective (Icos) de la deuxième composante de courant et la valeur effective (Ucos) de la deuxième composante de tension, pour obtenir une puissance réelle ($P^*$) virtuelle et **en ce que** la puissance carrée de la valeur effective (Urms) du signal de tension d'essai est divisée par la puissance réelle ($P^*$) virtuelle, pour déterminer la résistance d'isolation (Riso).

**Fig. 1**

**Fig. 2**

**Fig. 3**

**Fig. 4**

**Fig. 5**

**Fig. 6**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3882833 T2
- DE 2542811 B1
- EP 0654673 A1
- US 4200835 A
- US 20110270545 A1
- WO 2010078669 A1
- EP 2136449 A1
- DE 202006008936 U1
- DE 102011050590 A1
- WO 2012008022 A1